Europäisches Patentamt

European Patent Office

Office européen des brevets

(19)

(11) Publication number: **0 031 452**
**B1**

## EUROPEAN PATENT SPECIFICATION

(12)

(45) Date of publication of patent specification: **05.10.83**

(51) Int. Cl.³: **H 01 L 47/00**

(21) Application number: **80107240.6**

(22) Date of filing: **20.11.80**

(54) Oscillatory semi-conductor devices.

(30) Priority: **26.12.79 US 107478**

(43) Date of publication of application:
**08.07.81 Bulletin 81/27**

(45) Publication of the grant of the patent:
**05.10.83 Bulletin 83/40**

(84) Designated Contracting States:
**DE FR GB IT**

(56) References cited:
**FR - A - 1 401 207**
**US - A - 3 516 019**

JAPAN. J. APPLIED PHYSICS, vol. 15, no. 9,
September 1976 TOKYO (JP) O. WADA et al.:
"Current switching observed in planar Gunn-
effect device with thin active layer" pages
1827—1828
APPLIED PHYSICS LETTERS, vol. 27 no. 4,
August 15, 1975 NEW YORK (US) K.
KAMAKURA: "A new type of voltage controlled
negative resistance in thin samples of InSb"
pages 214—216

(73) Proprietor: **International Business Machines
Corporation
Old Orchard Road
Armonk, N.Y. 10504 (US)**

(72) Inventor: **Herman, Frank
15 Anderson Way
Menlo Park California 94025 (US)**

(74) Representative: **Lewis, Alan John
IBM United Kingdom Patent Operations Hursley
Park
Winchester, Hants, S021 2JN (GB)**

(56) References cited:
**PROCEEDINGS OF THE IRE, vol. 47, March 1959
NEW YORK (US) H. KRÖMER: "The physical
principles of a negative-mass amplifier" pages
397—406**

## Oscillatory semi-conductor devices

The invention relates to non-linear electric devices exhibiting the characteristic of negative resistance, and it particularly pertains to semiconductor devices and to circuit arrangements for applying electric fields thereto for producing desired negative-resistance characteristics.

Electric devices and/or circuit arrangements operating in modes which exhibit the characteristic of negative resistance are well known. A great many different arrangements have been devised. One class of arrangements for obtaining the effect is that concerned with semiconductor devices in which negative resistance characteristics are developed in the bulk of the semiconductor.

Prior art

There are structures and circuit arrangements in the prior art that are of interest with respect to the structure of the invention as will be found in the following U.S. patents:

| 3,204,115 | 8/1965 | Parmenter | 307/88.5 |
| 3,258,663 | 6/1966 | Weimer | 317/235 |
| 3,517,336 | 6/1970 | Wymanski | 331/107 |
| 3,626,257 | 12/1971 | Esaki et al | 317/234R |
| 3,626,328 | 12/1971 | Esaki et al | 331/107G |

And in the following publications:

Herbert Kromer; "Proposed Negative-Mass Microwave Amplifier"; "Physical Review"; Letter to the Editor; Vol. 109 No. 5, March 1, 1958; p 1856.

Herbert Kromer; "Physical Principles of a Negative-Mass Amplifier"; "Proceedings of the IRE"; Vol 47, March 1959; pp 397—406.

The patent to Parmenter discloses a four terminal semiconductor device exhibiting nega-. tive resistance between two terminals in response to control current applied to the other two terminals, and the semiconductor structure is subjected to transverse control current-output current flow. However, the device is a superconductive device and comprises three contiguous, bulk structural regions.

The patent to Weimer discloses a field effect transistor device. The device comprises a film of high resistivity material, less than 2000 nanometers (nm) thick, on a semi-conductor substrate. Source and drain electrodes are connected to the substrate and a control electrode to the film.

The patent to Symanski is directed to a semiconductor device for use in oscillator circuitry comprising a thin film stressed by electric potential and the application of photoradiation for spontaneously generating low frequency oscillations. This arrangement necessitates a 300 nanometers (nm) thin film of in depth of material having photoelectric transducing properties. A film of this thickness is to be contrasted with the very thin film used in performance of the Applicants invention.

The remaining patents to Esaki, Ludeke, Webster and Tsu and to Esaki, Ludeke and Tsu are directed to a semiconductor device structure that is applicable to a bulk oscillator circuit. The device comprises a superlattice structure comprising a multiple of pairs of semiconductor layers alternating in sequence interposed in an electric circuit and subjected to an electric field. Output energy is extracted by a cavity-type structure formed transverse to the superlattice structure. The electric current corresponding to the negative resistance product flows at right angles to the plane of the layers, in contradistinction to the device of the invention.

The publications to Kromer appear to be the closest teaching to that of the invention. Here the effect was sought with a semiconductor body of substantially three dimensions equally large with respect to the atomic radius of the material. The idea was proposed in 1957 by Herbert Kromer, who noted that at high kinetic energies, electrons and holes in semiconductor devices may exhibit negative effective masses. In an electric field the current contribution from negative-mass carriers is opposite to the electric field, and a semiconductor device containing a sufficient number of such carriers will exhibit negative resistance. However, it was recognized that any attempt to accelerate normal carriers up into the negative-mass energy range faces a difficulty that optical-phonon scattering and avalanche ionization will, in most cases, prevent the carriers from reaching that range.

It was pointed out that the negative masses occur at energies close to the band edge if the energy contours are re-entrant there, as is the case, for example, for the heavy holes in germanium. There, the energy contours are re-entrant along the six [100] directions. Along these directions then, the transverse effective masses are negative.

Accordingly, it was proposed that a microwave amplifier be arranged with a p-type Ge crystal with a strong dc bias field applied in the [100] direction with the electric rf field of a resonant cavity or a wave guide arranged perpendicular to it. The bias field could shift the total hole population toward the inside of a conical region of negative transverse mass. If the majority of the holes were brought inside this cone, the rf field would then be amplified. It was noted that in order to make this possible, it is necessary to avoid any scattering of the holes out of the negative-mass cone. The sought for results were not obtainable, however, with the reason therefor thought to be the result of germanium having too high a scattering cross-section.

The objects of the invention referred to indirectly hereinbefore and those that will appear as the specification progresses are attained in a semiconductor device comprising a layer of semiconductive material that is confined to a thickness of but a few atoms of the material. Since the layer is but a few "atomic layers" or a few particles thick, and in practice is from one to not more than four atoms or molecules thick, it is termed an oligatomic, or particularari foil hereinafter. Because "thin film" magnetic material is defined as that being 10,000 Ångstroms or less in thickness, the layer will be referred to hereinafter.

Accordingly the invention provides a non-linear electric device exhibiting the characteristic of negative resistance, comprising a semiconductor device and a circuit arrangement for applying electric fields thereto, said semiconductor device comprising an extended layer of semiconductor material exhibiting re-entrant constant energy level contours and negative effective charge carrier mass, a first pair of electrodes coupled to said layer at spaced positions for subjecting the layer to an electrical field produced by said circuit arrangement, a second pair of electrodes conductively connected to said layer at positions spaced apart in a direction transverse to the distance between the first pair of electrodes and an output circuit, pertaining to said circuit arrangement, connected to said second pair of electrodes, including a load element and terminals for connection across a source of energising potential, characterised in that said layer is supported on an atomically flat surface of a semi-conductor substrate and has a thickness of between 1 and 8 molecular or atomic diameters such that the device, when suitably energised by said circuit arrangement, provides an oscillator capable of sustaining oscillations.

The material of the extended layer is selected from a group of materials, each material of which has a much smaller band gap than that of the selected substrate. Examples of materials suitable for the substrate are GaAs, ZnSe, GaAlAs and the like, while materials suitable for the oligatomic layer are p-type Ge, Si GaAs, InSb and the like. The latter materials particularly have energy levels which, when graphically represented by a conventional two-dimensional constant energy contour plotting configuration, departs from the usual circular pattern to lie on a re-entrant closed line pattern. A three dimensional configuration results in a distorted spherical figure having six re-entrant "hollows", each representing a right circular cone of carrier negative effective mass. Narrowing the structure to substantially two dimensions reduces the number of such re-entrant sectors to four. These sectors are "cones" of extremely flattened elliptical cross-section.

An electric bias field applied across the "plane" of the thin foil in one direction tends to shift the charge carrier population into one of these conical sectors of negative transverse effective mass, thereby effecting a negative resistance manifestation across the "plane" of the thin foil in the other direction, or in other words, in a direction normal to that of the electric field. An energizing potential source and a load element are connected across the width of the layer as output circuitry for further developing and utilizing this negative resistance effect.

The invention will now be described in more detail, with reference to the accompanying drawing, in which:—

Fig. 1 is a cross-sectional elevation view of a thin foil semiconductor negative effective mass device according to the invention;

Fig. 2 is a plan view of that semiconductor effective negative mass device connected in a circuit arrangement therefor according to the invention;

Figs. 3 and 4 are graphical representations of typical energy levels and contours for materials used in the construction of the thin foil effective negative mass device according to the invention;

Fig. 5 is a cross-sectional elevation view of an alternate construction of an effective negative mass device according to the invention; and

Fig. 6 is a schematic diagram of a circuit arrangement according to the invention incorporating a thin foil semiconductor effective negative mass device according to the invention.

Description

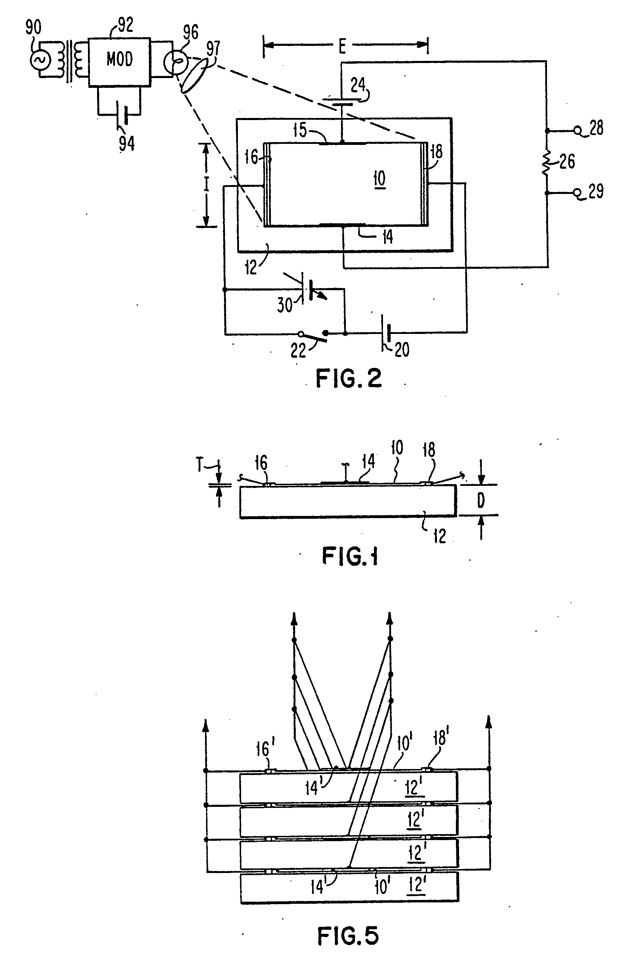

The essential structure of a thin foil semiconductor negative effective mass device according to the invention is depicted in Figs. 1 and 2. The prime object in the fabrication of the device according to the invention is to provide a thin foil 10 of semiconductor material that is sufficiently thick as to enable suitable interaction of an electric field with the flow of current carriers and such effects while at the same time is sufficiently thin as to prevent scattering of the carriers in the depth of the material. For strength and ease of fabrication the thin foil 10 is deposited on a substrate 12 of conventional semiconductor material such as gallium arsenide, GaAs, or zinc selenide, ZnSe, for example, and other materials as will be discussed hereinafter. The semiconductor material, for example p-type germanium or p-type silicon and the like, for the thin foil 10 has a lesser band gap than the material in the substrate 12. The substrate 12 has a thickness of depth D imparting sufficient strength for the support of the device, and at the same time affords a desired isolation for reducing electron-hole carrier scattering as described in greater detail hereinafter. The layer 10 has a thickness T which is but a few "atomic layers" or from one to not more than four atoms or molecules thick. Such a layer being but a few particles thick, termed an oligatomic or particularari thin foil herein is construed to be a foil from one to four particles, namely atoms or molecules, thick. The effect obtains with thin foils greater than four particles thick but it diminishes fast with greater thickness, having a tradeoff for the particular application at hand. The thickness T of the foil is therefore less than 1/10 of the thickness D of the substrate. A pair of "ohmic" or conducting contacts, of which only one 14 is shown, permit electric circuit connections across the width (designated I for convenience) of the foil 10, while a pair of conductors 16, 18 are spaced apart across the length (designated E for convenience) of the foil 10 and arranged as "non-injecting" contacts. Integrated circuit fabrication techniques are applied here. The surface of the substrate 12 on which the foil 10 is deposited preferably is a flat plane of variation not greater than the radius of one atom of the material. This atomically flat surface enables the foil 10 to be made as thin as possible. A preferred form of substrate 12 is a wafer of GaAs having an atomically flat [110] plane surface. The length and width dimensions I and E as depicted in Fig. 2 are of the order of 1 centimeter and are not particularly critical, except that the dimensions are chosen to reduce as much as possible any tendency toward carrier scattering.

An electric field of $10^3$—$10^6$ volts/centimeter, for example, is created across the foil 10 in one direction E by connecting a source 20 of direct bias potential through a switch 22 to conductors 16 and 18. Another source 24 of direct energizing potential and a load element, shown here as a resistor 26, are connected in series across the thin foil at right angles to the direction of the electric field. A shunt arrangement of energizing source and load element is readily substituted if that is desired. The thin foil 10 exhibits negative resistance across electrodes 14 and 15 under these conditions and current flows through the thin foil in the direction I and in the load resistor 26 across which an output potential is delivered to terminals 28 and 29. Varying the bias potential as by opening the switch 22 and varying the potential obtainable from a variable direct potential source 30, the current flowing in the load resistor 26 is modulated as desired.

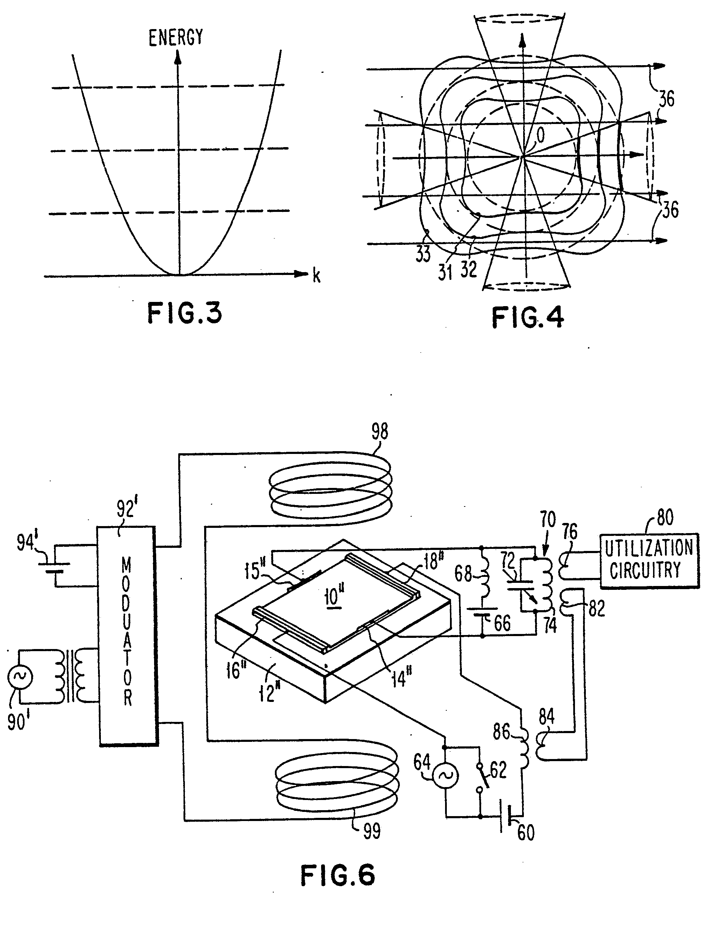

Figs. 3 and 4 are diagrams useful in an understanding of the invention. These diagrams schematically show energy levels and contours respectively for materials of interest in the practice of the invention. The materials are three dimensional and the models are based on energy levels and contours about a central point of origin. For many materials the models are spherical, while for other materials the models depart markedly. The particular diagrams are planar; the plane is passed through a three dimensional figure as desired for the problem at hand. For many materials the constant energy contours lie on concentric spheres and therefore are circular in the plane as shown in broken lines in Fig. 4. For materials of particular interest in practicing the invention, the models are sort of rounded cubical with six uniformly spaced dimples, and therefore the constant energy contours are reentrant as shown in Fig. 4. According to the invention, thin foils are utilized in order to approach as nearly as possible a two dimensional "plane" structure, although admittedly the foil has a real and definite thickness and therefore in fact the foil remains three dimensional. The energy level diagram of Fig. 3 seems to indicate the origin of the three contours 31, 32, 33 shown in Fig. 4. In an unbiased arrangement the carriers are concentrated in a cluster at the center denoted as the origin 0. Because of the re-entrant nature of the constant energy contours, negative transverse effective mass regions are established. In three dimensional arrangements, six right circular negative mass cones are formed with the apexes at the origin and extending in the directions of the dimples. In the thin foil according to the invention with an electric field applied as indicated by the arrows 36, the carriers are shifting into one of four negative mass regions in accordance with the direction of the electric field. According to the invention the negative mass regions comprise four extremely flattened elliptical cones of negative mass, one of which will be populated by negative mass holes because of the action of the electric field in shifting these holes into this sector. Scattering of the carriers is confined to the very thin almost two-dimensional constant energy contour. In this manner a scattering of the carriers out of the selected negative-mass cone is substantially obviated for all practical purposes and the desired negative resistance effect clearly obtains.

As thus far described, the invention is readily carried out with an insulating semiconductor substrate such as GaAs or ZnSe having the interface surface in the [110] plane on which is deposited a semiconductor thin foil a few atomic layers of p-type Ge or p-type Si which have degenerate valence band edges, and as a consequence, re-entrant constant energy surfaces in the Brillouin zone. An electric bias field applied by non-injecting contacts across the semiconductor thin foil is so oriented relative to the crystallographic axes that the current carriers (holes/electrons) are concentrated in a negative effective mass region of the Brillouin zone. The two-dimensional nature of the semiconductor thin foil according to the invention substantially prevents the scattering of carriers out of the negative mass region, as would occur in the three-dimensional bulk counterpart of Kromer. External circuitry is connected to the semiconductor thin foil by ohmic or conducting contacts at points establishing the leads perpendicular to the direction of the bias field. With this circuit arrangement the carriers exhibit negative transverse effective mass (negative resistance) insofar as the external circuitry is concerned. When the electric bias field is applied, the carriers will move into the negative transverse effective mass region, and because of the transverse negative resistance, energy will be supplied to the external circuitry, leading to oscillations of frequency determined by the external circuit parameters.

The use of elemental germanium or silicon, was predicated on the recognition that the top of their valence bands are known to have the type of constant energy surfaces known as re-entrant which indicate that negative transverse effective masses are obtainable. This re-entrant characteristic is a consequence of the degeneracy of the highest valence band at the zone center, combined with the fact that germanium and silicon have crystallographic centers of inversion. Considering the neighboring sphalerite compound gallium arsenide, there is again degeneracy at the zone center for the top-most valence band, but there is no center of inversion. The latter factor introduces an additional perturbation which splits the degeneracy as one moves away from the zone center, which structure leads to a multiple-ellipsoid valence band maximum in place of the desired re-entrant characteristic.

However, while many materials, for example GaAs, do not have centers of inversion in three-dimensional form, a reduction to an essentially two-dimensional form according to the invention wherein that structure comprising material of one or two, or a few atomic layers, the desired centers of inversion are observed. For example, a thin foil of GaAs in the [111] or [100] plane consists of all Ga or all As atoms, and a pair of [111] or [100] Ga and As layers exhibit a center of inversion in the plane between the two thin foils. Thus, if two such foils are arranged as a compound thin foil according to the invention, then such thin foils exhibit centers of inversion and re-entrant surfaces in the two-dimensional band structure. Therefore, the active region of the thin foil according to the invention is not restricted to materials such as germanium and silicon, but is open to much wider classes of two-dimensional semiconductors which have centers of inversion and hence re-entrant energy contours in their two-dimensional band structures. Since the magnitude of the re-entrant characteristic is related to the strength of the interaction between the highest valence band and the lower conduction bands, (all at the zone center), materials such as InSb or GaSb which have smaller direct band gaps than GaAs or Ge or Si, accordingly exhibit more appreciable re-entrant characteristics.

A single layer of GaAs is a neutral layer in the [110] plane because there are equal numbers of Ga and As atoms in such a layer, but there is no center of inversion. In contrast to such non-polar, or neutral, layers, an ionic layer obtains when a [100] or [111] layer is deposited, and it is necessary to deposit a pair (Ga and As) to obtain overall neutrality. When a non-polar thin film GaAs is deposited on a lattice-matched substrate, such as ZnSe, only a slight relaxation and little or no reconstruction obtains. More generally, the thin foil according to the invention alternately is a two-dimensional foil such as [100] or [111] GaAs, and a substrate is an insulating semiconductor alloy such as GaAlAs.

The reduction of the amount of material by approaching an essentially two-dimensional structure may result in a lack of the desired current. Such a lack is readily overcome according to the invention by paralleling a number of thin foil. devices as shown in Fig. 5. Here a multiple of substantially similar devices, for example Ge thin foils on GaAs substrates, are stacked and the connections are made in parallel to the circuitry for developing the negative resistance effect. The foils 12' are essentially the same as that described hereinbefore as are the supporting strata 12', which strata are sufficiently thick (at least 10 times as thick as the thin foil) as to provide mechanical support and also to prevent scattering of the carriers from one thin foil 10' to another.

Fig. 6 is a schematic diagram of an alternate circuit arrangement for utilizing the negative resistance device according to the invention. The device comprising a thin foil 10" on a substrate 12' is as essentially as described hereinbefore. The electric field is produced by a force of direct bias potential 60 supplied through a switch 62 or through any suitable modulating circuit arrangement shown here as a generator 64. Energizing potential is applied by means of a source 66 and a choke inductor 68 since the energizing potential source is connected in shunt to the device and to the load shown here as a tuned tank circuit 70. The resonant circuit 70 comprises a capacitor 72 and an inductor 74. It should be understood that in many applications either or both of these reactance components will consist partly, or even completely of stray reactance. It should also be understood that a series tuned circuit readily will be substituted if that is more desirable. A link winding 76 is coupled to the winding 74 for supplying a load 80 in more or less conventional manner. As thus described the circuit is utilized as an amplifying circuit. With the addition of another link winding 82 connected to a primary winding 84, which is coupled to a secondary winding 86 interposed in the electric field biasing circuit, positive or negative feedback, depending on the polarity of the respective windings, is applied for providing a negative feedback amplifying circuit or an oscillating circuit. Alternatively, capacitive feedback coupling is readily adapted by those skilled in the art.

The thin foil device in a circuit arrangement according to the invention is readily modulated in three other ways. First the device is extremely sensitive to the geometry of the components. Thus if the device is subjected to varying ambient pressure, the geometry will change and the output potential will vary accordingly. Hence it is contemplated that the arrangement according to the invention may be arranged essentially as a microphone or used in an instrumental application as a pressure sensor.

As shown in Fig. 2, a source 90 of modulating potential and the like is applied to a conventional modulating circuit 92, connected to a source 94 of energizing potential for modulating the output of a lamp 96. The modulated light output of the lamp 96 is focussed on the thin foil 10 as by an optical system, represented here only by a symbol for a lens 97. Preferably the lamp 96 is that of an infra-red radiation generator which will generate electron/hole carriers in the foil 10.

Referring to Fig. 6, there is shown an arrangement for modulating the thin foil 10″ by subjecting it to an electromagnetic field normal to the electric field and normal to the current flow. A source 90′ of modulating potential, a source of energizing potential 94′ and a conventional modulator 92′ are arranged to excite a magnetic field generator shown here as a pair of coils 98 and 99, between which the thin film device 10″ is conveniently arranged.

While the invention has been described in terms of express embodiments and alternatives suggested, it clearly should be understood that those skilled in the art will make changes as required for the application at hand without departing from the invention as defined in the appended claims, concluding the specification.

**Claims**

1. A non-linear electric device exhibiting the characteristic of negative resistance, comprising a semiconductor device and a circuit arrangement for applying electric fields thereto, said semiconductor device comprising an extended layer (10) of semiconductor material exhibiting re-entrant constant energy level contours and negative effective charge carrier mass, a first pair of electrodes (16, 18) coupled to said layer (10) at spaced positions for subjecting the layer to an electrical field produced by said circuit arrangement, a second pair of electrodes (14, 15) conductively connected to said layer (10) at positions spaced apart in a direction transverse to the distance between the first pair of electrodes (16, 18) and an output circuit, pertaining to said circuit arrangement, connected to said second pair of electrodes (15, 16), including a load element (26) and terminals for connection across a source of energising potential (24), characterised in that said layer (10) is supported on an atomically flat surface of a semi-conductor substrate (12) and has a thickness of between 1 and 8 molecular or atomic diameters such that the device, when suitably energised by said circuit arrangement, provides an oscillator capable of sustaining oscillations.

2. A device as claimed in claim 1, further characterised in that the layer (10) is not more than 4 (four) atoms or molecules thick.

3. A device as claimed in claim 1, further characterised in that the layer (10) is less than a few tenths of nanometers thick.

4. A device as claimed in claim 1, 2 or 3, further characterised in that the substrate (12) is formed of a semi-conductor material having its atomically flat surface in the [110] plane and has a thickness of the order of 10 (ten) times the thickness of the layer (10).

5. A device as claimed in any one of claims 1 to 4, further characterised in that the layer (10) is formed of Ge, Si, GaAs, GaSb, InSb, ZnSe, or GaAlAs.

6. A device as claimed in claim 1, further characterised in that the substrate (12) is composed of gallium-arsenate, the layer (10) is composed of p-type germanium, and the substrate interfaces the layer at the [110] plane.

7. A device as claimed in anyone of claims 1 to 6, further characterised by comprising a further arrangement (Fig. 2; 90, 92, 94, 96, 97; Fig. 6; 90′, 92′, 94′, 98, 99) for subjecting the layer (10) to a varying electromagnetic field thereby to modulate the output potential in the load element.

8. A device as claimed in claim 7, further characterised in that the arrangement comprises first means (96) for establishing an infra-red radiation and second means for energising the first means, said second means comprising a source (90) of modulating potential modulating a source of energising potential (94) used to energise the first means (96).

**Revendications**

1. Dispositif électrique non-linéaire ayant une caractéristique de résistance négative, comprenant un dispositif à semi-conducteur et un agencement de circuit pour lui appliquer des champs électriques, ledit dispositif à semi-conducteur comprenant une couche étendue (10) faite dans un matériau semi-conducteur offrant des contours de niveau d'énergie constante ré-entrants et une masse de porteurs de charge efficace négative, une première paire d'électrodes (16, 18) couplée à ladite couche (10) en des positions espacées pour soumettre la couche à un champ électrique produit par ledit agencement de circuit, une seconde paire d'électrodes (14, 15) connectée conductivement à ladite couche (10) en des positions espacées et selon une direction transversale à la distance séparant la première paire d'électrodes (16, 18) et un circuit de sortie, appartenant audit agencement de circuit, connecté à ladite seconde paire d'électrodes (14, 15) et comprenant un élément de charge (26) et des bornes de connexion à une source de potentiel d'excitation (24), caractérisé en ce que ladite couche (10) est supportée par une surface atomiquement plane d'un substrat semi-conducteur (12) et a une épaisseur comprise entre 1 et 8 diamètre d'atomes ou de molécules de sorte que le dispositif, lorsqu'il est excité de façon appropriée par ledit agencement de circuit, fournit un oscillateur capable de maintenir des oscillations.

2. Dispositif selon la revendication 1, caractérisé en outre en ce que la couche (10) a une épaisseur ne dépassant pas 4 (quatre) atomes ou molécules.

3. Dispositif selon la revendication 1, caractérisé en outre en ce que la couche (10) a une épaisseur inférieure à quelques dizaines de nanomètres.

4. Dispositif selon les revendications 1, 2, ou 3, caractérisé en outre en ce que le substrat est fait dans un matériau semi-conducteur dont la surface atomiquement plane se trouve dans le plan [110], et dont l'épaisseur est environ 10 (dix) fois l'épaisseur de la couche (10).

5. Dispositif selon l'une quelconque des revendications 1 à 4, caractérisé en outre en ce que la couche (10) est faite de Ge, Si, GaSb, InSb, ZnSe ou GaAlAs.

6. Dispositif selon la revendication 1, caractérisé en outre en ce que le substrat (12) est fait d'arséniure de gallium, la couche (10) est faite de Germanium de type p, et le substrat fait interface avec la couche dans le plan [110].

7. Dispositif selon l'une quelconque des revendications 1 à 6, caractérisé en outre en ce qu'il comprend un autre agencement (Figure 2: 90, 92, 94, 96, 97; Figure 6: 90', 92', 94', 98, 99) afin de soumettre la couche (10) à un champ électromagnétique variable pour moduler le potentiel de sortie dans l'élément de charge.

8. Dispositif selon la revendication 7, caractérisé en outre en ce que l'agencement comprend des premiers moyens (96) de rayonnement à infra-rouge et des seconds moyens d'excitation des premiers moyens, lesdits seconds moyens comprenant une source de modulation de potentiel (90) modulant une source de potentiel d'excitation (94) utilisée pour exciter les premiers moyens (96).

**Patentansprüche**

1. Nicht-lineare elektrische Einheit mit negativer Widerstandscharakteristik, die ein Halbleiterteil und eine Schaltung zum Anlegen elektrischer Felder an diesen Halbleiterteil umfaßt, der aus einer erweiterten Schicht aus Halbleitermaterial (10) mit wiedereinspringendem konstantem Energie-Niveauverlauf und negativ wirkenden Ladungssträgen, einem Paar mit der genannten Schicht (10) in bestimmten Abständen gekoppelten Elektroden (16, 18), die diese Schicht dem von der Schaltungsanordnung erzeugten elektrischen Feld aussetzen, einem leitend mit der Schicht (10) an voneinander entfernten Positionen quer zum Abstand zwischen dem ersten Paar von Elektroden (16, 18) leitend verbundenen zweiten Paar von Elektroden (14, 15) und einer zu der Schaltungsanordnung gehörenden Ausgangsschaltung, die mit dem besagten zweiten Paar von Elektroden (14, 15) verbunden ist und ein Lastelement (26) und Anschlüsse zur Verbindung mit einer Erregungspotentialquelle (24) enthält, besteht, dadurch gekennzeichnet, daß die erweiterte Schicht aus Halbleitermaterial (10) auf einer atomar ebenen Oberfläche eines Halbleitersubstrates (12) gelagert ist und eine Dicke zwischen 1 und 8 Molekül- oder Atomdurchmessern hat, so daß die Einheit bei geeigneter Erregung durch die genannte Schaltungsanordnung einen Oszillator bildet, der Schwingungen aufrechterhalten kann.

2. Einheit nach Anspruch 1, weiter dadurch gekennzeichnet, daß die Schicht aus Halbleitermaterial (10) höchstens vier Atome oder Molekühle dick ist.

3. Einheit nach Anspruch 1, weiter dadurch gekennzeichnet, daß die Schicht aus Halbleitermaterial (10) dünner ist als einige Zehntel Nanometer.

4. Einheit nach einem der Ansprüche 1, 2 oder 3, weiter dadurch gekennzeichnet, daß das Substrat (12) aus einem Halbleitermaterial gebildet wird, dessen atomar ebene Oberfläche in der Ebene 110 liegt und das zehnmal so dick ist wie die genannte Schicht aus Halbleitermaterial (10).

5. Einheit nach einem der Ansprüche 1 bis 4, weiter dadurch gekennzeichnet, daß die genannte Schicht aus Halbleitermaterial (10) aus Ge, Si, GaAs, GaSb, InSb, ZnSe oder GaAlAs gebildet wird.

6. Einheit nach Anspruch 1, weiter dadurch gekennzeichnet, daß das Substrat (12) aus Galliumarsenid, die Schicht aus Halbleitermaterial (10) aus P-leitendem Germanium bestehen und das Substrat an der Schicht in der Ebene 110 anliegt.

7. Einheit nach einem der Ansprüche 1 bis 6, weiter dadurch gekennzeichnet, daß sie eine weitere Schaltungsanordnung (Fig. 2: 90, 92, 94, 96, 97; Fig. 6: 90', 92', 94', 98, 99) enthält, um die Schicht aus Halbleitermaterial (10) wechselnden elektromagnetischen Feldern auszusetzen und dadurch das Ausgangspotential im Lastelement zu modulieren.

8. Einheit nach Anspruch 7, weiter dadurch gekennzeichnet, daß die Anordnung erste Einrichtungen (96) zum Aufbau einer Infrarotstrahlung und zu deren Erregung eine zweite Einrichtung enthält, die aus einer Modulationspotentialquelle (90) zur Modulation einer Erregungspotentialquelle (94) besteht, mit der die erste Einrichtung (96) erregt wird.

FIG.2

FIG.1

FIG.5

FIG.3

FIG.4

FIG.6

2